# FASCICULE DE BREVET EUROPEEN

(11) **EP 3 496 218 B1**
(45) Date de publication et mention de la délivrance du brevet: **05.01.2022**
(21) Numéro de dépôt: 18204487.5
(22) Date de dépôt: 06.11.2018
(51) Int. Cl.: H02B 11/133, H02B 11/10

(54) **DISPOSITIF DE RACCORDEMENT D'UN CHARIOT MOBILE PORTANT UN APPAREILLAGE ELECTRIQUE A UNE CELLULE MOYENNE OU HAUTE TENSION, ET CELLULE COMPORTANT UN TEL DISPOSITIF**
ANSCHLUSSVORRICHTUNG EINES BEWEGLICHEN SCHLITTENS MIT EINEM ELEKTRISCHEN GERÄT AN EINE ZELLE MIT MITTLERER ODER HOHER SPANNUNG, UND ZELLE, DIE EINE SOLCHE VORRICHTUNG UMFASST
DEVICE FOR CONNECTING A MOBILE CARRIAGE CARRYING AN ELECTRICAL APPARATUS TO A MEDIUM OR HIGH VOLTAGE CELL, AND CELL COMPRISING SUCH A DEVICE

(30) Priorité: 07.12.2017 FR 1761766
(43) Date de publication de la demande: 12.06.2019
(73) Titulaire: Schneider Electric Industries SAS, 92500 Rueil Malmaison (FR)
(72) Inventeur: TERPEND, Serge, 38050 GRENOBLE (FR); BENTLEY, Jon-Paul, 38050 GRENOBLE (FR)
(74) Mandataire: Colette, Marie-Françoise

(56) Documents cités:
- WO-A1-2015/044053
- FR-A1- 2 594 265
- FR-A1- 2 782 579
- US-A- 5 434 369

## Description

### DOMAINE TECHNIQUE

La présente invention concerne un dispositif de raccordement mécanique et électrique d'un chariot mobile portant un appareillage électrique à une cellule moyenne ou haute tension, ledit dispositif de raccordement comportant un écrou d'entraînement appartenant à la cellule précitée apte à coopérer avec un crochet appartenant au chariot précité pour entraîner le chariot vers une position d'embrochage de l'appareillage à la cellule, un connecteur d'auxiliaire électrique de la cellule apte à coopérer avec un connecteur d'auxiliaire électrique complémentaire du chariot mobile.

Le terme « appareillage électrique » utilisé regroupe indifféremment tout appareil du type interrupteur, disjoncteur, contacteur, sectionneur, interrupteur fusible, recloser, etc. L'invention est particulièrement adaptée pour la conduite et la surveillance des réseaux électriques haute tension, c'est-à-dire d'une tension supérieure à 1000V.

### ETAT DE LA TECHNIQUE ANTERIEURE

Une cellule d'appareillage électrique haute tension comporte habituellement une structure métallique avec plusieurs compartiments distincts. On peut y trouver un compartiment dit « jeu de barres » placé par exemple à l'arrière de la cellule et où sont regroupées les barres métalliques conductrices du réseau électrique, un compartiment dit « appareillage » qui comporte un appareil interrupteur, lequel peut être monté sur un chariot mobile de façon à être débrochable, c'est-à-dire déconnectable du jeu de barres, un compartiment dit « câbles » pour la partie de raccordement de câbles et qui comporte généralement les capteurs pour les mesures de courants/tensions, et un compartiment appelé d'habitude caisson « basse tension » qui comporte le système de protection et de contrôle de l'appareil interrupteur avec notamment un ou plusieurs relais de protection et commande.

Dans ce compartiment dit « appareillage » dans lequel se situent le chariot et l'appareil électrique, sont logés aussi des moyens d'entraînement motorisés du chariot mobile, lesquels moyens sont destinés à mouvoir le chariot mobile entre une position embrochée, dans laquelle les broches sont respectivement connectées aux barres amont et aval de la cellule d'appareillage, et une position débrochée, dans laquelle les broches sont déconnectées des barres. Ces moyens d'entraînement comprennent un moteur d'entraînement qui fait par exemple tourner une vis sans fin sur laquelle est montée un écrou, ainsi que des moyens d'accrochage du chariot à l'écrou de manière à permettre son entraînement par les moyens précités. Une telle cellule comporte également des connecteurs auxiliaires aptes à être connectés électriquement à des connecteurs auxiliaires complémentaires du chariot, ces auxiliaires étant destinés à assurer les connexions électriques et informatiques entre la cellule et l'appareil interrupteur.

Ces auxiliaires peuvent être par exemple des connecteurs de puissance pour alimenter les bobines de déclenchement/enclenchement et véhiculer l'information de la position ouverte ou fermée de l'appareil par l'intermédiaire d'une connexion avec le relais de protection.

Actuellement, cette connexion entre les connecteurs appartenant à la cellule et ceux appartenant au chariot, est réalisée soit manuellement soit automatiquement à l'embrochage de l'appareillage sur le jeu de barres par l'intermédiaire de connecteurs placés respectivement sur le chariot et la cellule.

Lorsque cette connexion est réalisée manuellement, cela nécessite la mise en œuvre de mécanismes d'inter verrouillage permettant d'obturer l'accès à la manivelle d'entraînement de la vis sans fin permettant le déplacement de l'appareillage, lorsque la prise manuelle n'est pas bien enclenchée.

De la même manière, le verrouillage entre la cellule et le disjoncteur s'effectue manuellement, ce qui nécessite la mise en œuvre de mécanismes d'inter verrouillage afin d'assurer que ce verrouillage est correctement effectué avant la réalisation des manœuvres d'embrochage de l'appareil sur les barres, ce mécanisme d'inter verrouillage permettant d'obturer là-encore l'accès à la vis sans fin.

On connaît les documents FR 2 594 265 A1 et FR 2 782 579 A1 décrivant des dispositifs de raccordement mécanique et électrique d'un chariot mobile portant un appareillage électrique à une cellule moyenne ou haute tension. Les dispositifs selon ces documents comprennent une cellule ayant un mécanisme de crochet pour engager le chariot mobile et le déplacer dans une position connectée et une position déconnectée.

### EXPOSE DE L'INVENTION

La présente invention résout ces problèmes et propose un dispositif de raccordement mécanique et électrique d'un appareillage électrique monté sur un chariot mobile à une cellule moyenne tension, ce dispositif permettant de réduire considérablement le nombre d'inter verrouillages requis pour la mise en œuvre de ce raccordement tout en assurant une qualité de contact constante entre les connecteurs tout le long du déplacement de l'appareillage, de sa position de test jusqu'à la position embrochée, que ce soit dans le sens de l'embrochage ou bien du débrochage.

A cet effet, la présente invention a pour objet un dispositif de raccordement selon la revendication 1.

Selon l'invention, ces moyens dits premiers comportent le crochet précité monté articulé par rapport à un support du chariot mobile et comportant une encoche apte à coopérer avec l'écrou précité, ledit crochet étant apte lors de l'insertion du chariot, à venir en butée sur l'écrou, puis à tourner dans le sens antihoraire à l'encontre de moyens de rappel, avant d'être rappelé en position d'accrochage sur l'écrou par les moyens de rappel, effectuant alors une rotation dans le sens horaire.

Selon l'invention, ce dispositif comporte des moyens dits troisièmes, pour relier mécaniquement le connecteur électrique d'auxiliaire de la cellule à l'écrou précité, de telle manière que ce connecteur suive le mouvement du chariot mobile après le raccordement mécanique du chariot à la cellule réalisé, tout le long du déplacement entre la position test correspondant à la position accrochée du chariot sur la cellule, et la position embrochée.

Selon une autre caractéristique, ces moyens dits troisièmes comportent des moyens pour assurer la pression de contact entre les deux connecteurs.

Selon l'invention, le support du connecteur d'auxiliaire de cellule est monté coulissant le long d'une glissière appartenant à la cellule. Selon une autre caractéristique, le levier précité est monté articulé d'une part, par rapport à l'écrou, et d'autre part, par rapport au support du connecteur d'auxiliaire de cellule précité.

Selon une autre caractéristique, ces moyens dits troisièmes comportent en outre un ressort interposé entre une partie appartenant au levier et le support du connecteur d'auxiliaire précité, ledit ressort étant apte à exercer une pression de contact entre les deux connecteurs en position raccordée électriquement de ces deux connecteurs.

Selon une autre caractéristique, ces moyens de compensation comportent une lumière dite première prévue à l'une des extrémités du levier précité et apte à coopérer avec l'écrou puis, prévue également dans le levier entre l'axe d'articulation du levier au support et un point de fixation du ressort précité au levier, une lumière dite seconde, apte à coopérer avec un plot du support, ces deux lumières et le ressort coopérant avec l'écrou et le support de telle manière que, lors d'une course supplémentaire de l'appareillage après la connexion des connecteurs précités, cette course étant nécessaire pour que le crochet vienne se bloquer sur l'écrou, le support se déplace sur la glissière, entraînant la rotation du levier par rapport au support dans le sens anti-horaire par l'intermédiaire des deux lumières précitées, ceci entraînant une traction du ressort, cette traction du ressort, en combinaison avec le déplacement du levier par rapport au plot et l'écrou précité, par l'intermédiaire des deux lumières précitées, permettant d'obtenir une compensation des variations dimensionnelles des connecteurs.

Selon une autre caractéristique, les connecteurs précités sont destinés à assurer les connexions électriques et informatiques entre la cellule et l'appareillage.

Selon une autre caractéristique, ces connecteurs comportent huit connecteurs de puissance destinés à alimenter les bobines de déclenchement/enclenchement et véhiculer l'information de position ouverte ou fermée des contacts de l'appareillage, ou bien un contacteur du type RJ 45, destiné à relier un automate appartenant au chariot à un automate appartenant à la cellule.

Selon une autre caractéristique, l'écrou d'entraînement précité est monté sur la vis sans fin d'un moteur d'entraînement appartenant au chariot mobile.

La présente invention a encore pour objet une cellule d'appareillage moyenne ou haute tension, cette cellule étant caractérisée en ce qu'elle comporte un dispositif de raccordement comportant les caractéristiques précédemment mentionnées prises seules ou en combinaison.

Mais d'autres avantages et caractéristiques de l'invention apparaîtront mieux dans la description détaillée qui suit et se réfère aux dessins annexés donnés uniquement à titre d'exemple et dans lesquels :
- La figure 1 est une vue en perspective d'une partie de cellule électrique moyenne tension selon l'invention équipée d'un dispositif de raccordement selon l'invention, avant la mise en place du chariot dans la cellule,
- La figure 2 est une vue en perspective illustrant un chariot mobile supportant un appareillage,
- La figure 3 est une vue en perspective d'une partie de la cellule selon l'invention pendant le montage du chariot mobile à l'intérieur de la cellule,
- La figure 4 est une vue en perspective de ladite partie de cellule, après le montage du chariot à l'intérieur de la cellule, la porte de ladite cellule étant ouverte, et
- Les figures 5 à 9 sont des vues en plan du dispositif de raccordement selon l'invention, ces figures correspondant respectivement à différentes étapes du raccordement du chariot mobile à la cellule.

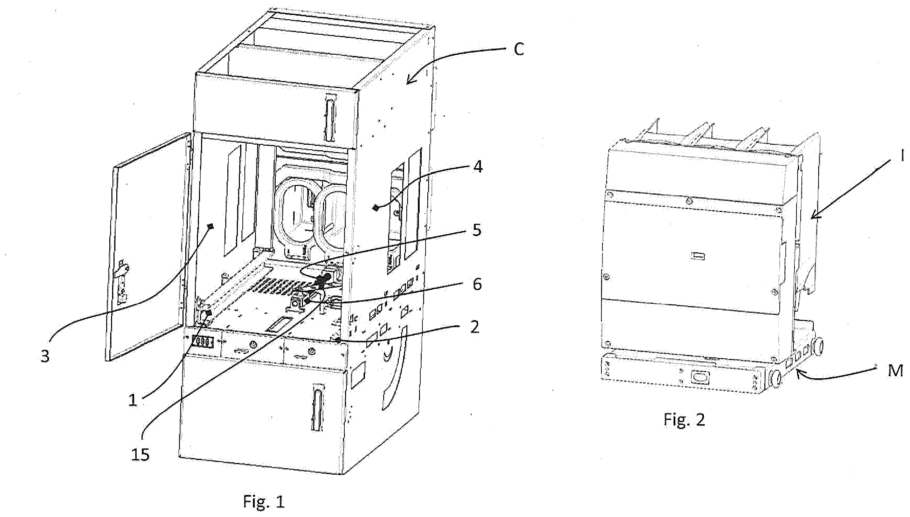

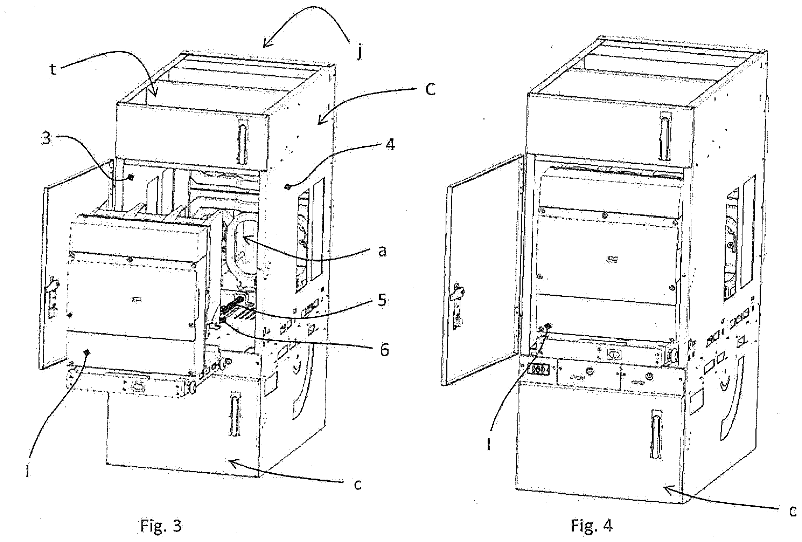

Sur les figures 1 à 4, l'on voit une partie de cellule d'appareillage électrique haute tension C comportant, logés dans une structure métallique, plusieurs compartiments distincts, à savoir un compartiment (j) dit « jeu de barres », situé à l'arrière de la cellule et où sont regroupées les barres métalliques conductrices du réseau électrique, un compartiment (a) dit « appareillage » destiné à comporter un appareil interrupteur I monté sur un chariot mobile M, un compartiment (c) dit « câbles » permettant le raccordement de certains éléments de la cellule au moyen de câbles et qui comporte généralement les capteurs pour les mesures de courants/tensions, et un compartiment (t) appelé habituellement caisson « basse tension » qui comporte le système de protection et de contrôle de l'appareil interrupteur avec notamment un ou plusieurs relais de protection et commande.

Tel que ceci est visible sur les figures 1 à 4, ce compartiment dit « appareillage » (a) comporte deux rails de guidage 1,2 situés à la partie inférieure du compartiment et contre les faces intérieures respectivement des deux parois latérales 3,4 de la cellule C, ces rails étant destinés à faciliter l'insertion du chariot mobile à l'intérieur dudit compartiment.

Dans ce compartiment « appareillage » (a), sont logés aussi des moyens d'entraînement motorisés du chariot mobile M qui sont destinés à déplacer le chariot mobile M entre une position embrochée, dans laquelle les broches de l'appareillage sont respectivement connectées aux barres amont et aval de la cellule, et une position débrochée, dans laquelle les broches sont déconnectées de ces barres.

Ces moyens d'entraînement comprennent un moteur d'entraînement qui fait par exemple tourner une vis sans fin 5 autour de laquelle est monté un écrou 6 de telle manière que la rotation de la vis entraine le déplacement de l'écrou. Cette vis est liée mécaniquement au chariot M, par l'intermédiaire de moyens d'accrochage destinés à coopérer avec un plot 6a de l'écrou 6 précité de manière à permettre l'accrochage du chariot à l'écrou précité lorsque le chariot est suffisamment introduit dans le compartiment « appareillage » (a).

De manière connue en soi, le compartiment « appareillage » (a) comporte également des connecteurs dits d'auxiliaires 7 de la cellule C aptes à être amenés en contact avec des connecteurs dits d'auxiliaires 8 du chariot mobile M, de manière à permettre la circulation de signaux basse tension ou informatiques entre le chariot M et la cellule C.

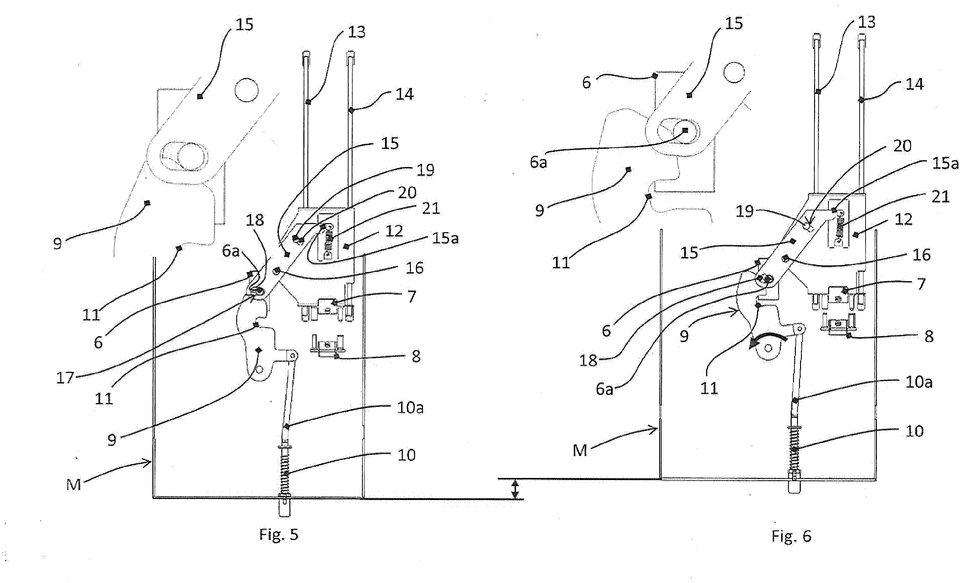

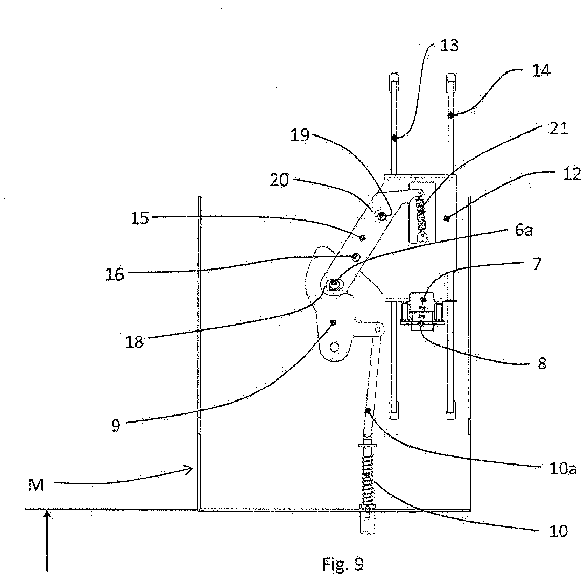

Tel qu'illustré sur les figures 5 à 9, le dispositif de raccordement selon l'invention comporte, pour sa partie destinée à réaliser le raccordement mécanique du chariot M à la cellule C, un crochet 9 monté articulé par rapport à un support du chariot mobile M et rappelé par un ressort 10 dans le sens horaire en position d'accrochage avec l'écrou 6, ledit crochet 9 comportant une encoche 11 apte à coopérer avec l'écrou 6 de la vis précité 5 de telle manière que pendant le mouvement d'insertion du chariot mobile M dans le compartiment « appareillage » (a), le crochet 9 vienne en contact avec l'écrou 6, puis tourne dans le sens anti-horaire à l'encontre de la force du ressort 10 jusqu'à ce que l'écrou 6 vienne se loger dans l'encoche précitée 11 réalisant ainsi l'accrochage mécanique du chariot M sur la cellule C, ce qui correspond à une position dite test de l'appareillage, cet accrochage permettant au chariot M d'être déplacé par le mécanisme d'entraînement précité vers une position d'embrochage du chariot, au jeu de barres de la cellule.

Selon l'invention également, ce dispositif de raccordement réalise, en même temps que l'accrochage mécanique précité, la connexion électrique entre les deux connecteurs d'auxiliaires précités 7,8. Pour ce faire, le connecteur 7 d'auxiliaire de la cellule et le connecteur 8 d'auxiliaire du chariot sont situés l'un par rapport à l'autre respectivement dans la cellule C et dans le chariot M, de telle manière que la connexion électrique entre les deux connecteurs 7,8 soit réalisée lorsque le chariot M est en position accrochée sur l'écrou 6, position dite position test.

Selon une réalisation particulière de l'invention illustrée sur les figures 1 à 9, l'écrou 6 d'entraînement est relié mécaniquement au connecteur d'auxiliaire 7 de la cellule C, de telle manière que, après l'accrochage du crochet 9 sur l'écrou 6, cet écrou 6 entraîne en même temps l'appareillage I et le connecteur 7 d'auxiliaire de la cellule C.

Pour ce faire, le connecteur 7 d'auxiliaire de la cellule est monté sur un support 12 dit support du connecteur auxiliaire de la cellule C, lequel support 12 est monté coulissant sur une glissière formée par deux rails 13,14 solidaires d'un support fixe par rapport à la cellule. L'écrou précité 6 est relié mécaniquement au support précité 12 du connecteur auxiliaire de telle manière que le déplacement du chariot mobile M vers la position de l'appareil connectée au jeu de barres, entraîne le déplacement suivant une même direction du support 12 de connecteur d'auxiliaire de la cellule.

Ces moyens de liaison mécaniques entre l'écrou 6 et le support 12 du connecteur auxiliaire 7 de la cellule, comprennent un levier 15 monté articulé d'une part, autour d'un axe fixe 16 du support de connecteur auxiliaire 12, et relié mécaniquement à l'écrou 6 par l'intermédiaire d'un orifice 17 prévu dans le levier 15 apte à coopérer avec ledit écrou.

Selon l'invention, ce dispositif de raccordement comporte en outre des moyens dits de compensation aptes à compenser les variations dimensionnelles de toutes les pièces impliquées dans la connexion, de manière à assurer une qualité de contact constante entre les deux connecteurs 7,8 quelles que soient ces variations dimensionnelles.

Ces moyens de compensation comprennent une lumière 18, dite première, prévue dans le levier précité 15 constituant l'orifice précité 17 apte à coopérer avec le plot 6a de l'écrou précité 6, une lumière 20, dite seconde, prévue dans le levier 15, et apte à coopérer avec un plot 19 appartenant au support 12 de connecteur auxiliaire de la cellule, et un ressort 21 interposé entre une partie d'extrémité 15a du levier 15 et le support 12 de connecteur d'auxiliaire de la cellule, ce ressort étant apte à être amené dans une position de traction lorsque les deux connecteurs 7,8 sont en position connectée et l'appareil I en position verrouillée dans la cellule par le crochet 9, ou position test, de manière à assurer une qualité de connexion constante entre les deux connecteurs 7,8 indépendamment des variations dimensionnelles des connecteurs, par une rotation du levier 15 coopérant avec les lumières dites première et seconde 18,20, lesquelles lumières 18,20 coopèrent respectivement avec l'écrou 6 et le plot 19.

Le fonctionnement du dispositif de raccordement selon l'invention va être décrit dans ce qui suit en référence aux figures.

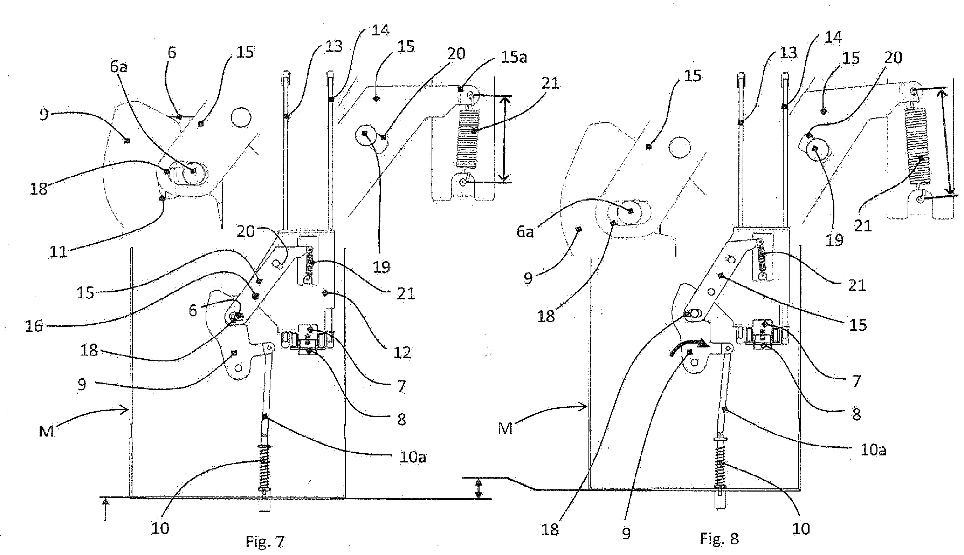

L'on procède tout d'abord à une avancée manuelle de l'appareil I, jusqu'au contact du crochet 9 sur l'écrou d'entraînement 6. Après cette mise en contact, lorsqu'on continue à avancer l'appareil I, ce crochet 9 tourne dans le sens antihoraire autour de son axe d'articulation par rapport au châssis du chariot mobile M, tel que ceci est illustré sur la figure 6. Lorsque les deux connecteurs 7,8 arrivent en position de connexion, tel qu'illustré sur la figure 7, le crochet 9 a suffisamment tourné pour que l'écrou 6 puisse commencer à être introduit dans l'encoche 11 du crochet 9, ce qui permet le retour en position initiale du crochet 9 par l'intermédiaire du ressort 10 associé à la tige 10a, position dans laquelle le crochet 9 bloque l'appareil I dans la cellule C par l'intermédiaire de l'écrou d'entraînement 6, ce qui correspond à la position test de l'appareil.

Dans cette position, l'écrou d'entraînement 6 monté sur la vis sans fin 5 du moteur d'entraînement du chariot M, peut alors entraîner en même temps l'appareil I et le support 12 du connecteur auxiliaire 7 de la cellule, lors de la manœuvre de raccordement de l'appareil I sur le jeu de barres.

Dans cette réalisation particulière, le support 12 du connecteur d'auxiliaire de la cellule est positionné dans la cellule par le levier 15, le ressort 21, l'écrou 6 d'entraînement, et la glissière 13,14.

Le ressort 21 avant la connexion des connecteurs auxiliaires 7,8, positionne avec un certain effort le levier 15 sur le support de connecteur 12 à l'intérieur de la lumière dite seconde 20.

L'effort exercé lors de la connexion des deux connecteurs 7,8 est beaucoup plus faible que l'effort exercé par le ressort 21 au point de contact du levier 15 sur le support de connecteur 12 à l'intérieur de la lumière dite seconde 20 de manière à garantir la connexion entre les deux connecteurs.

Par conception, et tel qu'illustré sur les figures 7 et 8, l'appareil I doit réaliser une course supplémentaire après la connexion des connecteurs 7,8 pour que le crochet 9 soit déplacé en rotation jusqu'à ce que l'écrou 6 soit placé au fond de l'encoche 11 dudit crochet 9.

Cette course supplémentaire réalisée par l'appareil I, permettant d'obtenir le verrouillage du chariot M dans la cellule C, entraîne le déplacement du support 12 de connecteur auxiliaire de la cellule sur la glissière 13,14, par l'intermédiaire du crochet 9 exerçant une poussée sur l'écrou 6, lequel écrou 6 exerce une poussée sur le levier 15, ce qui entraîne le déplacement du support 12 de connecteur auxiliaire de la cellule C.

Ce déplacement du support 12 sur la glissière 13,14, entraîne la rotation du levier 15 autour de son point d'articulation 16 au support 12 dans le sens antihoraire, le déplacement de la lumière 18 du levier 15 sur le plot 6a de l'écrou 6, et le déplacement de la lumière 20 par rapport au plot 19, ce qui permet d'augmenter la tension du ressort 21.

Cette augmentation de la tension du ressort 21 permet d'assurer une pression sur le connecteur 7 de la cellule C, cette pression permettant d'assurer la connexion entre les deux connecteurs 7,8 en compensant les variations dimensionnelles des pièces.

Dans cette position, l'appareil I monté sur le chariot M peut être entraîné par l'écrou 6 monté sur la vis sans fin 5 de manière à réaliser la connexion de l'appareil I sur le jeu de barres de la cellule. Pendant ce mouvement, l'écrou 6 d'entraînement entraîne également le support 12 de connecteur via le levier 15, lequel support 12 coulisse le long des tiges 13,14 formant glissières.

Ainsi, le système d'accrochage du chariot M permet de connecter en même temps automatiquement les connecteurs d'auxiliaire électriques 7,8 au moment de la mise en place du chariot M dans la cellule C, cette mise en place conduisant au verrouillage du chariot M dans la cellule C.

On notera que lors du mouvement inverse de décrochage du chariot, il est nécessaire d'appuyer sur un bouton poussoir situé en face avant du chariot, ce qui a pour effet de venir libérer le crochet de l'écrou.

On obtient grâce à l'invention les avantages suivants :
On obtient un contact positif entre les deux connecteurs, lesquels ne subissent pas les effets de l'inertie de l'appareil lors de l'insertion de celui-ci, compte tenu de la présence du ressort qui absorbe ces effets.

Le système de connexion compense automatiquement les variations dimensionnelles de toutes les pièces impliquées dans la connexion.

Ce système de connexion assure un contact positif pendant les opérations de connexion et de déconnexion des connecteurs tout le long du déplacement entre la position test ou accrochée, et la position embrochée. L'invention permet également de réduire les efforts nécessaires pour réaliser la connexion et la déconnexion par le fait que c'est l'inertie de l'appareillage électrique qui établit le contact.

L'invention permet également de réduire le nombre d'inter verrouillages qu'il est nécessaire de réaliser, par le fait que le raccordement mécanique du chariot à la cellule et le raccordement électrique des connecteurs, ne sont plus réalisés manuellement mais automatiquement.

Ainsi, les inter-verrouillages ne sont plus nécessaires, comme ceci était le cas lorsque la connexion électrique des connecteurs était réalisée manuellement.

De même, les inter-verrouillages requis auparavant pour s'assurer de l'engagement correct de l'appareillage dans la cellule avant les manœuvres destinées au raccordement de l'appareil au jeu de barres, ne sont plus nécessaires.

L'invention permet également de réaliser la connexion des connecteurs auxiliaires automatiquement, dès la position de test de l'appareillage, c'est-à-dire avant l'embrochage sur le jeu de barres, de manière à conserver la possibilité de réaliser tous les tests dans cette position, comme on l'a dans le cas de la connexion manuelle, tout en gardant les avantages de simplification d'une connexion automatique.

Et l'on souhaite garantir la qualité de cette connexion tout le long du déplacement de l'appareillage, de sa position de test jusqu'à la position embrochée, que ce soit dans le sens de l'embrochage ou bien dans le sens du débrochage.

## Revendications

1. Dispositif de raccordement mécanique et électrique d'un chariot mobile (M) portant un appareillage électrique (I) à une cellule moyenne ou haute tension (C), comprenant le chariot mobile (M) et le cellule moyenne ou haute tension (C); le dispositif comprenant en outre:
- un écrou (6) d'entraînement appartenant à la cellule précitée (C) apte à coopérer avec un crochet (9) appartenant au chariot précité (M) pour entraîner le chariot vers une position d'embrochage de l'appareillage du chariot M à la cellule (C),
- un connecteur d'auxiliaire électrique (7) de la cellule (C) apte à coopérer avec un connecteur d'auxiliaire électrique complémentaire (8) du chariot mobile (M),
ledit dispositif comportant des moyens, dits premiers, permettant de réaliser l'accrochage du crochet précité (9) sur l'écrou (6) automatiquement lors de l'insertion du chariot (M) dans la cellule (C) jusqu'à la position dite test dans
laquelle l'appareillage (I) est dans la cellule (C) sans être embroché, et des moyens dits seconds, permettant de réaliser en même temps que cet accrochage, la connexion électrique automatique des deux connecteurs (7,8) respectivement de la cellule (C) et du chariot (M), de telle manière qu'après cette connexion, le déplacement du connecteur (7) appartenant à la cellule (C) devienne dépendant de celui (8) du chariot mobile (M) entre la position dite de test et la position embrochée de l'appareillage (I), et
inversement entre la position embrochée et la position dite de test, ces moyens dits premiers comportent le crochet précité (9) monté articulé par rapport à un support du chariot mobile (M) et
comportant une encoche (11) apte à coopérer avec l'écrou précité (6), ledit crochet (9) étant apte lors de l'insertion du chariot (M), à venir en butée sur l'écrou (6), puis à tourner dans le sens antihoraire à l'encontre de moyens de rappel (10,10a), avant d'être rappelé en position d'accrochage sur l'écrou (6) par les moyens de rappel, effectuant alors une rotation dans le sens horaire, ces moyens dits seconds consistent en ce que les deux connecteurs précités (7,8) sont placés l'un par rapport à l'autre, respectivement dans la cellule (C) et sur le chariot (M), de telle manière que ces deux connecteurs (7,8) soient amenés en position de connexion électrique en position accrochée du crochet (9) sur l'écrou (6), le dispositif comporte des moyens dits troisièmes, pour relier mécaniquement le connecteur électrique d'auxiliaire (7) de la cellule (C) à l'écrou précité (6), de telle manière que ce connecteur (7) suive le mouvement du chariot mobile (M) après le raccordement mécanique du chariot (M) à la cellule (C) réalisé, tout le long du déplacement entre la position test ou position accrochée et la position embrochée, ces moyens dits troisièmes comportent un levier (15) interposé entre l'écrou d'entraînement (6) et un support (12) du connecteur d'auxiliaire (7) de la cellule (C), de telle manière que, lorsque le crochet (9) du chariot (M) est accroché à l'écrou d'entraînement (6), le levier (15) entraîne le support (12) du connecteur d'auxiliaire (7) de la cellule (C) lors du déplacement du chariot (M), et le support (12) du connecteur d'auxiliaire (7) de cellule (C) est monté coulissant le long d'une glissière (13,14) appartenant à la cellule (C).

2. Dispositif de raccordement selon la revendication 1 dans lequel ces moyens dits troisièmes comportent des moyens pour assurer la pression de contact entre les deux connecteurs (7,8).

3. Dispositif de raccordement selon la revendication 1 ou 2, qui comporte des moyens de compensation dits quatrièmes, aptes à compenser les variations dimensionnelles de toutes les pièces impliquées dans la connexion, de manière à assurer une qualité de contact constante entre les deux connecteurs (7,8).

4. Dispositif de raccordement selon la revendication 3, dans lequel les moyens dits troisièmes précités comportent les moyens de compensation dits quatrièmes.

5. Dispositif de raccordement selon la revendication 1, dans lequel le levier précité (15) est monté articulé d'une part, par rapport à l'écrou (6), et d'autre part, par rapport au support (12) du connecteur d'auxiliaire (7) de cellule précité (C).

6. Dispositif de raccordement selon la revendication 1 ou 5, dans lequel ces moyens dits troisièmes comportent en outre un ressort (21) interposé entre une partie (15a) appartenant au levier (15) et le support (12) du connecteur d'auxiliaire précité (7), ledit ressort (21) étant apte à exercer une pression de contact entre les deux connecteurs (7,8) en position raccordée électriquement de ces deux connecteurs.

7. Dispositif de raccordement selon la revendication 6, dans lequel ces moyens de compensation comportent une lumière (18), dite première, prévue à l'une des extrémités du levier précité (15) et apte à coopérer avec l'écrou (6) puis, prévue également dans le levier (15) entre l'axe d'articulation (16) du levier (15) au support (12) et un point de fixation du ressort précité (21) au levier (15), une lumière dite seconde (20), apte à coopérer avec un plot (9) du support (12), ces deux lumières (18,20) et le ressort (21) coopérant avec l'écrou (6) et le support (12) de telle manière que, lors d'une course supplémentaire de l'appareillage (I) après la connexion des connecteurs précités (7,8), cette course étant nécessaire pour que le crochet (9) vienne se bloquer sur l'écrou (6), le support (12) se déplace sur la glissière (13,14), entraînant la rotation du levier (15) par rapport au support (12) dans le sens anti-horaire par l'intermédiaire des deux lumières précitées (18,20), ceci entraînant une traction du ressort (21), cette traction du ressort, en combinaison avec le déplacement du levier (15) par rapport au plot (9) et l'écrou précité (6), par l'intermédiaire des deux lumières précitées (18,20), permettant d'obtenir une compensation des variations dimensionnelles des connecteurs (7,8).

8. Dispositif de raccordement selon l'une quelconque des revendications précédentes, dans lequel les connecteurs précités (7,8) sont destinés à assurer les connexions électriques et informatiques entre la cellule (C) et l'appareillage (I).

9. Dispositif de raccordement selon la revendication 8, dans lequel ces connecteurs comportent huit connecteurs de puissance destinés à alimenter les bobines de déclenchement/enclenchement et véhiculer l'information de position ouverte ou fermée des contacts de l'appareillage, ou bien un contacteur du type RJ 45 destiné à relier un automate appartenant au chariot à un automate appartenant à la cellule.

10. Dispositif de raccordement selon l'une quelconque des revendications précédentes, dans lequel l'écrou d'entraînement précité (6) est monté sur la vis sans fin (5) d'un moteur d'entraînement appartenant au chariot mobile (M).

11. Cellule d'appareillage moyenne ou haute tension, qui comporte un dispositif de raccordement selon l'une quelconque des revendications précédentes.

## Patentansprüche

1. Vorrichtung zum mechanischen und elektrischen Verbinden eines beweglichen Schlittens (M), der eine elektrische Anlage (I) trägt, mit einer Mittel- oder Hochspannungszelle (C), die den beweglichen Schlitten (M) und die Mittel- oder Hochspannungszelle (C) enthält; wobei die Vorrichtung außerdem Folgendes umfasst:
- eine Antriebsmutter (6), die zu der Zelle (C) gehört und mit einem Haken (9), der zu dem Schlitten (M) gehört, zusammenwirken kann, um den Schlitten in eine Position zum Einstecken der Anlage des Schlittens (M) in die Zelle (C) anzutreiben,
- einen elektrischen Hilfsverbinder (7) der Zelle (C), der mit einem komplementären elektrischen Hilfsverbinder (8) des beweglichen Schlittens (M) zusammenwirken kann,
wobei die Vorrichtung erste Mittel enthält, die ermöglichen, das Verankern des Hakens (9) an der Mutter (6) automatisch zu verwirklichen, wenn der Schlitten (M) in die Zelle (C) bis in die Prüfposition, in der die Anlage (I) sich in der Zelle (C) befindet, ohne eingesteckt zu sein, eingesetzt wird, und zweite Mittel enthält, die ermöglichen, gleichzeitig mit dem Verankern die automatische elektrische Verbindung der beiden Verbinder (7, 8) der Zelle (C) bzw. des Schlittens (M) zu verwirklichen, derart, dass nach diesem Verbinden die Verlagerung des Verbinders, der zu der Zelle (C) gehört, von der Verlagerung jenes (8) des beweglichen Schlittens (M) zwischen der Prüfposition und der in die Anlage (I) eingesteckten Position und umgekehrt zwischen der eingesteckten Position und der Prüfposition abhängt,
wobei die ersten Mittel den Haken (9) enthalten, der in Bezug auf einen Träger des beweglichen Schlittens (M) gelenkig montiert ist und eine Kehle (11) aufweist, die mit der Mutter (6) zusammenwirken kann, wobei der Haken (9) beim Einführen des Schlittens (M) an der Mutter (6) anschlagen kann und sich dann im Gegenuhrzeigersinn entgegen Rückstellmitteln (10, 10a) drehen kann, bevor er durch die Rückstellmittel in die Einhakposition an der Mutter (6) zurückgeführt wird und anschließend eine Drehung im Uhrzeigersinn ausführt, wobei diese zweiten Mittel darin bestehen, dass die beiden Verbinder (7, 8) relativ zueinander in der Zelle (C) bzw. auf dem Schlitten (M) angeordnet werden, derart, dass diese beiden Verbinder (7, 8) in der verankerten Position des Hakens (9) an der Mutter (6) in die Position einer elektrischen Verbindung gebracht werden,
wobei die Vorrichtung dritte Mittel enthält, um den elektrischen Hilfsverbinder (7) der Zelle (C) mit der Mutter (6) mechanisch zu verbinden, derart, dass dieser Verbinder (7) der Bewegung des beweglichen Schlittens (M) nach dem erfolgten mechanischen Verbinden des Schlittens (M) mit der Zelle (C) längs der Verlagerung zwischen der Prüfposition oder der verankerten Position und der eingesteckten Position folgt,
wobei diese dritten Mittel einen Hebel (15) enthalten, der zwischen der Antriebsmutter (6) und einem Träger (12) des Hilfsverbinders der Zelle (C) eingefügt ist, derart, dass dann, wenn der Haken (9) des Schlittens (M) an der Antriebsmutter (6) verankert ist, der Hebel (15) den Träger (12) des Hilfsverbinders (7) der Zelle (C) antreibt, wenn der Schlitten (M) verlagert wird, und dass der Träger (12) des Hilfsverbinders (7) der Zelle (C) längs einer Gleitstange (13, 14), die zu der Zelle (C) gehört, gleitend montiert ist.

2. Verbindungvorrichtung nach Anspruch 1, wobei diese dritten Mittel Mittel enthalten, um den Kontaktdruck zwischen den beiden Verbindern (7, 8) sicherzustellen.

3. Verbindungvorrichtung nach Anspruch 1 oder 2, die vierte Ausgleichsmittel enthält, die die Abmessungsschwankungen sämtlicher an der Verbindung beteiligten Teile ausgleichen können, derart, dass zwischen den beiden Verbindern (7, 8) eine konstante Kontaktqualität sichergestellt ist.

4. Verbindungvorrichtung nach Anspruch 3, wobei die dritten Mittel die vierten Ausgleichsmittel enthalten.

5. Verbindungsvorrichtung nach Anspruch 1, wobei der Hebel (15) einerseits in Bezug auf die Mutter (6) und andererseits in Bezug auf den Träger (12) des Hilfsverbinders (7) der Zelle (C) gelenkig montiert ist.

6. Verbindungvorrichtung nach Anspruch 1 oder 5, wobei die dritten Mittel außerdem eine Feder (21) enthalten, die zwischen einem Teil (15a), der zu dem Hebel (15) gehört, und dem Träger (12) des Hilfsverbinders (7) eingefügt ist, wobei die Feder (21) zwischen den beiden Verbindern (7, 8) in der Position einer elektrischen Verbindung dieser beiden Verbinder einen Kontaktdruck ausüben kann.

7. Verbindungsvorrichtung nach Anspruch 6, wobei die Ausgleichsmittel ein erstes Langloch (18), das an einem der Enden des Hebels (15) vorgesehen ist und mit der Mutter (6) zusammenwirken kann und außerdem in dem Hebel (15) zwischen der Anlenkungsachse (16) des Hebels (15) am Träger (12) und einem Befestigungspunkt der Feder (21) am Hebel (15) vorgesehen ist, und ein zweites Langloch (20), das mit einer Kontaktstelle (9) des Trägers (12) zusammenwirken kann, aufweisen, wobei diese beiden Langlöcher (18, 20) und die Feder (21) mit der Mutter (6) und dem Träger (12) in der Weise zusammenwirken, dass auf einem zusätzlichen Weg der Anlage (I) nach dem Verbinden der Verbinder (7, 8), wobei dieser Weg notwendig ist, damit der Haken (9) an der Mutter (6) blockiert wird, der Träger (12) sich längs der Gleitstange (13, 14) verlagert und dabei die Drehung des Hebels (15) in Bezug auf den Träger (12) im Gegenuhrzeigersinn über die beiden Langlöcher (18, 20) antreibt, wodurch ein Auseinanderziehen der Feder (21) bewirkt wird, wobei diese Auseinanderziehen der Feder in Kombination mit der Verlagerung des Hebels (15) in Bezug auf die Kontaktstelle (9) und die Mutter (6) über die beiden Langlöcher (18, 20) ermöglicht, einen Ausgleich der Abmessungsschwankungen der Verbinder (7, 8) zu erhalten.

8. Verbindungsvorrichtung nach einem der vorhergehenden Ansprüche, wobei die Verbinder (7, 8) dazu bestimmt sind, die elektrischen und datentechnischen Verbindungen zwischen der Zelle (C) und der Anlage (I) sicherzustellen.

9. Verbindungsvorrichtung nach Anspruch 8, wobei diese Verbinder acht Leistungsverbinder, die dazu bestimmt sind, die Auskupplungs/Einkupplungs-Spulen zu speisen und Informationen über die geöffnete oder geschlossene Position der Kontakte der Anlage zu transportieren, oder ein Stecker des Typs RJ 45, der dazu bestimmt ist, einen Automaten, der zu dem Schlitten gehört, mit einem Automaten, der zu der Zelle gehört, zu verbinden, umfassen.

10. Verbindungsvorrichtung nach einem der vorhergehenden Ansprüche, wobei die Antriebsmutter (6) an der Endlosschraube (5) eines Antriebsmotors, der zu dem beweglichen Schlitten (M) gehört, montiert ist.

11. Mittel- oder Hochspannungs-Zelle für Anlagen, die eine Verbindungsvorrichtung nach einem der vorhergehenden Ansprüche enthält.

## Claims

1. Device for mechanically and electrically connecting a mobile trolley (M) carrying an electrical item of equipment (I) to a medium-voltage or high-voltage cell (C), comprising the mobile trolley (M) and the medium-voltage or high-voltage cell (C); the device further comprising:
- a drive nut (6) belonging to the aforementioned cell (C) and able to interact with a hook (9) belonging to the aforementioned trolley (M) in order to drive the trolley to a position in which the item of equipment of the trolley (M) is engaged with the cell (C);
- an auxiliary electrical connector (7) of the cell (C) able to interact with a complementary auxiliary electrical connector (8) of the mobile trolley (M),
said device including what are termed first means that make it possible to fasten the aforementioned hook (9) on the nut (6) automatically when the trolley (M) is inserted into the cell (C) as far as what is termed the test position, in which the item of equipment (I) is in the cell (C) without being engaged, and what are termed second means that make it possible, at the same time as this fastening, to automatically electrically connect the two connectors (7, 8), of the cell (C) and of the trolley (M), respectively, in such a way that, after this connection, the movement of the connector (7) belonging to the cell (C) becomes dependent on that (8) of the mobile trolley (M) between what is termed the test position and the engaged position of the item of equipment (I), and vice versa between the engaged position and what is termed the test position, these what are termed first means include the aforementioned hook (9) mounted in an articulated manner with respect to a support of the mobile trolley (M) and including a notch (11) able to interact with the aforementioned nut (6), said hook (9) being able, as the trolley (M) is being inserted, to come into abutment against the nut (6), then to turn in the anticlockwise direction counter to the return means (10, 10a), before being returned to the position in which it is hooked on the nut (6) by the return means, then rotating in the clockwise direction, these what are termed second means consist in that the aforementioned two connectors (7, 8) are placed with respect to one another, in the cell (C) and on the trolley (M), respectively, such that these two connectors (7, 8) are brought into an electrical connection position in the position in which the hook (9) is hooked on the nut (6), the device includes what are termed third means for mechanically linking the auxiliary electrical connector (7) of the cell (C) to the aforementioned nut (6), such that this connector (7) follows the motion of the mobile trolley (M) after the trolley (M) has been mechanically connected to the cell (C), all the way along the movement between the test position or hooked position and the engaged position, these what are termed third means include a lever (15) interposed between the drive nut (6) and a support (12) of the auxiliary connector (7) of the cell (C) such that, when the hook (9) of the trolley (M) is hooked onto the drive nut (6), the lever (15) drives the support (12) of the auxiliary connector (7) of the cell (C) as the trolley (M) moves, and the support (12) of the auxiliary connector (7) of the cell (C) is mounted so as to slide along a runner (13, 14) belonging to the cell (C).

2. Connecting device according to Claim 1, in which these what are termed third means include means for providing contact pressure between the two connectors (7, 8).

3. Connecting device according to Claim 1 or 2, which includes what are termed fourth compensating means, able to compensate for the variations in the dimensions of all of the parts involved in the connection so as to provide a constant quality of contact between the two connectors (7, 8).

4. Connecting device according to Claim 3, in which the aforementioned what are termed third means include the what are termed fourth compensating means.

5. Connecting device according to Claim 1, in which the aforementioned lever (15) is mounted in an articulated manner both with respect to the nut (6) and with respect to the support (12) of the auxiliary connector (7) of the aforementioned cell (C).

6. Connecting device according to Claim 1 or 5, in which these what are termed third means further include a spring (21) interposed between a portion (15a) belonging to the lever (15) and the support (12) of the aforementioned auxiliary connector (7), said spring (21) being able to exert a contact pressure between the two connectors (7, 8) in the position in which these two connectors are electrically connected.

7. Connecting device according to Claim 6, in which these compensating means include what is termed a first window (18) provided at one of the ends of the aforementioned lever (15) and able to interact with the nut (6) then, also provided in the lever (15) between the axis of articulation (16) of the lever (15) with respect to the support (12) and a point of attachment of the aforementioned spring (21) to the lever (15), what is termed a second window (20) that is able to interact with a pad (9) of the support (12), these two windows (18, 20) and the spring (21) interacting with the nut (6) and the support (12) such that, over an additional travel of the item of equipment (I) after the aforementioned connectors (7, 8) have been connected, this travel being required for the hook (9) to catch onto the nut (6), the support (12) moves over the runner (13, 14), rotating the lever (15) with respect to the support (12) in the anticlockwise direction via the aforementioned two windows (18, 20), this tensioning the spring (21), this tensioning of the spring, in combination with the movement of the lever (15) with respect to the pad (9) and the aforementioned nut (6), via the aforementioned two windows (18, 20), making it possible to compensate for variations in the dimensions of the connectors (7, 8).

8. Connecting device according to any one of the preceding claims, in which the aforementioned connectors (7, 8) are intended to provide the electrical and data connections between the cell (C) and the item of equipment (I).

9. Connecting device according to Claim 8, in which these connectors include eight power connectors that are intended to supply power to the trip/engagement coils and convey the information on the open or closed position of the contacts of the item of equipment, or else an RJ45 contactor that is intended to link a controller belonging to the trolley to a controller belonging to the cell.

10. Connecting device according to any one of the preceding claims, in which the aforementioned drive nut (6) is mounted on the worm screw (5) of a drive motor belonging to the mobile trolley (M).

11. Medium-voltage or high-voltage equipment cell, which includes a connecting device according to any one of the preceding claims.
